# EUROPÄISCHE PATENTSCHRIFT

(11) **EP 3 947 753 B1**
(45) Veröffentlichungstag und Bekanntmachung des Hinweises auf die Patenterteilung: **07.12.2022**
(21) Anmeldenummer: 20715357.8
(22) Anmeldetag: 27.03.2020
(51) Int. Cl.: C21D 1/68, C25D 5/10, C25D 3/22, C25D 3/20, C23C 28/00, C23C 2/40, C23C 2/06, C23C 2/04, C23C 2/02, C21D 6/00, C21D 1/74, C21D 1/70, C23C 30/00, C25D 5/50, C25D 5/36, C25D 7/06, C25D 17/10

(54) **VERFAHREN ZUR HERSTELLUNG EINES STAHLBANDES MIT VERBESSERTER HAFTUNG METALLISCHER SCHMELZTAUCHÜBERZÜGE**
METHOD FOR PRODUCING A STEEL SHEET WITH IMPROVED ADHESION OF METALLIC HOT-DIP COATINGS
PROCÉDÉ DE PRODUCTION D'UNE TÔLE D'ACIER AVEC UNE ADHÉRENCE AMÉLIORÉE DE REVÊTEMENTS MÉTALLIQUES À CHAUD

(30) Priorität: 01.04.2019 DE 102019108459
(43) Veröffentlichungstag der Anmeldung: 09.02.2022
(73) Patentinhaber: Salzgitter Flachstahl GmbH, 38239 Salzgitter (DE)
(72) Erfinder: KÖHLER, Kai, 47259 Duisburg (DE); KÖPPER, Nils, 47259 Duisburg (DE); LUTHER, Friedrich, 47259 Duisburg (DE); DEBEAUX, Marc, 47259 Duisburg (DE)
(74) Vertreter: Moser Götze & Partner Patentanwälte mbB
(86) Internationale Anmeldenummer: PCT/EP2020/058809
(87) Internationale Veröffentlichungsnummer: WO 2020/201136

(56) Entgegenhaltungen:
- EP-A1- 2 010 690
- EP-A1- 2 798 094
- EP-A1- 3 017 073
- GB-A- 1 496 398
- JP-A- H05 239 605
- US-A- 5 447 802
- US-A1- 2010 065 160
- US-A1- 2012 125 491
- US-A1- 2017 145 529
- US-A1- 2017 198 152
- US-A1- 2018 010 224

## Beschreibung

Die Erfindung betrifft ein Verfahren zur Herstellung eines kalt- oder warmgewalzten Stahlbandes mit einem metallischen Überzug, das Stahlband Eisen als Hauptbestandteil und neben Kohlenstoff, einen Mn-Gehalt von 8,1 bis 25,0 Gewichts-% und optional eines oder mehrere der Legierungselemente Al, Si, Cr, B, Ti, V, Nb und/oder, Mo aufweist, wobei die Oberfläche des unbeschichteten Stahlbandes zunächst gereinigt wird, danach auf die gereinigte Oberfläche eine sauerstoffhaltige, eisenbasierte Schicht aufgebracht wird, die mehr als 5 Massenprozent Sauerstoff enthält, danach das Stahlband mit der sauerstoffhaltigen, eisenbasierten Schicht glühbehandelt wird und zur Erzielung einer im Wesentlichen aus metallischem Eisen bestehenden Oberfläche im Zuge der Glühbehandlung in einer reduzierenden Ofenatmosphäre reduktionsbehandelt wird und anschließend das so behandelte und glühbehandelte Stahlband mit dem metallischen Überzug schmelztauchbeschichtet wird. Des Weiteren betrifft die Erfindung ein Stahlband mit einem mittels Schmelztauchen aufgebrachten metallischen Überzug sowie die Verwendung eines solchen Stahlbandes.

Für die durch Schmelztauchen aufgebrachten Beschichtungen beziehungsweise Legierungsbeschichtungen sind unter anderem Aluminium-Silizium (AS/AlSi), Zink (Z), Zink-Aluminium (ZA), Zink-Eisen (ZF/Galvannealed), Zink-Magnesium-Aluminium (ZM/ZAM) und Aluminium-Zink (AZ) bekannt. Diese Korrosionsschutzbeschichtungen werden üblicherweise in kontinuierlichen Durchlaufverfahren in einem Schmelzbad auf das Stahlband (Warm- oder Kaltband) aufgebracht.

Aus der Offenlegungsschrift WO 2013/007578 A2 ist bekannt, dass hochfeste Stähle mit höheren Gehalten an Elementen in Gewichts-% bis zu 35,0 % Mn, bis zu 10,0 % Al, bis zu 10,0 % Si, bis zu 5,0 % Cr im Zuge der dem schmelztauchbeschichteten vorgeschalteten Glühung des Stahlbandes, selektiv passive, nicht benetzbare Oxide auf der Stahloberfläche bilden, wodurch die Haftung des Überzugs auf der Stahlbandoberfläche verschlechtert wird und dies gleichzeitig zur Ausbildung von unverzinkten Stellen führen kann. Diese Oxide bilden sich auf Grund der herrschenden Glühatmosphäre, die zwangsläufig immer geringe Spuren an H₂O oder O₂ enthält und oxidierend auf die genannten Elemente wirkt.

Offenbart wird in der genannten Schrift unter anderem ein Verfahren, bei dem im Zuge einer Glühung unter oxidierenden Bedingungen in einem ersten Schritt eine Voroxidation des Stahlbandes stattfindet, mit der eine gezielt deckende FeO-Schicht erzeugt wird, die eine selektive externe Oxidation der Legierungselemente verhindert. In einem zweiten Schritt wird diese Schicht anschließend wieder zu metallischem Eisen reduziert.

Die Patentschrift DE 10 2013 105 378 B3 offenbart ein Verfahren zur Herstellung eines Stahlflachprodukts, welches neben Eisen und unvermeidbaren Verunreinigungen in Gewichts-% bis zu 35 Mn, bis zu 10 Al, bis zu 10 Si und bis zu 5 Cr enthält. Nach einem Aufwärmen in einem Vorwärmofen, in welchem das Stahlflachprodukt einer oxidierenden Atmosphäre ausgesetzt wird und einem rekristallisierenden Glühen im Glühofen, in dem eine gegenüber FeO reduzierend wirkende Glühatmosphäre herrscht, wird das Stahlflachprodukt im Schmelztauchbad beschichtet.

Die Offenlegungsschrift DE 10 2010 037 254 A1 offenbart ein Verfahren zum Schmelztauchbeschichten eines Stahlflachproduktes, wobei das Stahlflachprodukt aus einem nicht rostenden Stahl erzeugt ist, der neben Eisen und unvermeidbaren Verunreinigungen in Gewichts-% enthält: 5 bis 30 Cr, < 6 Mn, < 2 Si und < 0,2 Al. Das Stahlflachprodukt wird zunächst unter einer oxidierenden Voroxidationsatmosphäre erwärmt, unter einer reduzierenden Halteatmosphäre gehalten und sodann durch ein Schmelzbad geleitet.

Aus der Patentschrift DE 693 12 003 T2 ist weiterhin ein Verfahren zur Herstellung eines beschichteten Stahlbleches mit reduzierten Oberflächenfehlern bekannt, bei welchem auf mindestens eine Oberfläche eines Stahlbandes eine Beschichtung aus Zink oder einer Zinklegierung aufgetragen ist. Zusätzlich sind unmittelbar unter der Beschichtung aus Zink oder einer Zinklegierung eine Schicht aus Fe und unmittelbar unter der Schicht aus Fe eine Schicht, in der sauerstoffaffine Elemente des Stahls konzentriert sind, vorgesehen. Das kohlenstoffarme oder sehr kohlenstoffarme Stahlband, auf das die Fe-Plattierung appliziert ist, enthält mindestens eine Komponente, ausgewählt aus der Gruppe Si, Mn, P, Ti, Nb, Al, Ni, Cu, Mo, V, Cr und B in einer Menge von mindestens 0,1 Gew.-% für Si, Ti, Ni, Cu, Mo, Cr und V und mindestens 0,5 Gew.-% für Mn, mindestens 0,05 Gew.-% für P, Al und Nb und mindestens 0,001 Gew.-% für B. Die Schicht aus Fe weist ein Auftraggewicht von 0,1 bis 10 g/m², einen Sauerstoffgehalt von 0,1 bis 10 Gew.-% und einen Kohlenstoffgehalt von 0,01 Gew.-% bis weniger als 10 Gew.-% auf. Ziel soll hierbei sein, dass an der Grenzfläche zwischen der sauerstoffhaltigen Fe-Schicht und dem Stahlband während des Glühens vor der Schmelztauchbeschichtung eine Schicht entsteht, in der im Stahl enthaltenen sauerstoffaffinen Elemente konzentriert sind. Hierdurch soll die weitere Diffusion der im Stahl enthaltenen sauerstoffaffinen Elemente in Richtung auf die Fe-Plattieroberfläche verhindert werden und eine gute Verzinkbarkeit realisieren.

Des Weiteren ist aus der Offenlegungsschrift US 2018 / 0 119 263 A1 ein Verfahren zur Herstellung eines kaltgewalzten Stahlbandes mit einem Mn-Gehalt zwischen 1 und 6 Gewichts-% und einem C-Gehalt kleiner 0,3 Gewichts-% und mit einem metallischen Überzug bekannt. Hierbei wird das Stahlband mit einer Schicht aus reinem Eisen elektroplattiert, dann die Eisenschicht zu einer Eisenoxidschicht oxidiert und anschließend bei einer Temperatur zwischen 750 °C und 900 °C in einer Atmosphäre mit 1 bis 20 Volumen-% Wasserstoff reduziert. Anschließend wird mittels Schmelztauchbeschichten ein Zink-Überzug aufgebracht.

Auch ist in der Offenlegungsschrift US 2004 / 0 121 162 A1 bereits ein kalt- oder warmgewalztes Stahlband mit bis zu 0,5 Gewichts-% C und mit bis zu 15 Gewichts-% Mn und mit einer Beschichtung beschrieben. Die Beschichtung weist ausgehend von dem Stahlband eine Eisenplattierung und einen metallischen Zinküberzug auf.

Ferner offenbart die Offenlegungsschrift CN 109 477 191 A ein weiteres kalt- oder warmgewalztes beschichtetes Stahlband mit einer Beschichtung. Das Stahlband weist 0,08 bis 0,3 Gewichts-% C, 3,1 bis 8,0 Gewichts-% Mn, 0,01 bis 2,0 Gewichts-% Si, 0,001 bis 0,5 Gewichts-% Al auf. Die Beschichtung besteht aus einer Schicht basierend auf elementarem Eisen sowie einem hierauf mittels Schmelztauchbeschichten aufgebrachten metallischen Überzug. Der metallische Überzug ist aus Zink, Zink-Eisen, Zink-Aluminium oder Zink-Aluminium-Magnesium.

In der Offenlegungsschrift EP 2 918 696 A1 ist ein weiteres Stahlband aus 0,05 bis 0,50 Gewichts-% C, 0,5 bis 5,0 Gewichts-% Mn, 0,2 bis 3,0 Gewichts-% Si und 0,001 bis 1,0 Gewichts-% Al beschrieben, das mit einer Zn-Fe-Legierung schmelztauchbeschichtet ist. Das Stahlband weist an seiner Grenzfläche zu der Zn-Fe-Beschichtung eine Schicht mit mindestens 50 Volumen-% Ferrit und mindestens 90 % unoxidiertem Eisen auf. Außerdem zeigt die Offenlegungsschrift WO 2015/ 001 367 A1 ein Stahlband mit einem Mn-Gehalt zwischen 3,5 und 10,0 Gewichts-% und einem C-Gehalt zwischen 0,1 und 0,5 Gewichts-%, auf dem eine Unterschicht aus reinem Ferrit mit einer Schichtdicke zwischen 10 und 50 µm, eine weitere Unterschicht aus Eisen und Oxiden mit einer Schichtdicke zwischen 1 und 8 µm und eine Deckschicht aus reinem Eisen mit einer Schichtdicke von 50 bis 300 nm angeordnet ist. Auf der Deckschicht erfolgt eine Schmelztauchbeschichtung mit Al, Zn oder Legierungen hiervon.

Es hat sich allerdings gezeigt, dass bei Mn-Gehalten von über 8,1 bis 25,0 Gewichts-% im Stahl bei allen vorbekannten Lösungen zur Verbesserung der Benetzbarkeit der Stahloberfläche noch keine zufriedenstellende, reproduzierbare Haftung des Überzugs erzielt werden kann.

Ursächlich hierfür ist die Ausbildung eines massiven Saums von Oxiden der Legierungselemente an der Unterseite der (nach einer reduzierenden Glühung dann reduzierten) Eisenoxidschicht bzw. sauerstoffhaltigen Eisenschicht. Dieser Oxidsaum aus Oxiden der Legierungselemente stellt eine Schwachstelle des Systems in Bezug auf die Haftung dar. Das heißt, an der Grenzfläche der reduzierten Eisenoxidschicht bzw. sauerstoffhaltigen Eisenschicht zum Stahlsubstrat kann hier oftmals ein Haftungsversagen z. B. bei einem Umformprozess beobachtet werden.

Aufgabe der Erfindung ist es deshalb, ein Verfahren zur Herstellung eines kalt- oder warmgewalzten Stahlbandes mit einem metallischen Überzug anzugeben, das neben Kohlenstoff, Eisen als Hauptbestandteil, einen Mn-Gehalt von 8,1 bis 25,0 Gewichts-% und optional weitere sauerstoffaffine Elemente, wie zum Beispiel Al, Si, Cr, B, enthält, welches unabhängig von der aktuellen Legierungszusammensetzung des Stahlbandes, gleichmäßige und reproduzierbare Haftungsbedingungen für den Überzug auf der Stahlbandoberfläche liefert.

Die Lehre der Erfindung umfasst ein Verfahren zur Herstellung eines kalt- oder warmgewalzten Stahlbandes mit einem metallischen Überzug mit verbesserter Haftung, das Stahlband Eisen als Hauptbestandteil und neben Kohlenstoff, einen Mn-Gehalt von 8,1 bis 25,0 Gewichts-% und optional eines oder mehrere der Legierungselemente Al, Si, Cr, B, Ti, V, Nb und/oder, Mo aufweist, wobei die Oberfläche des unbeschichteten Stahlbandes zunächst gereinigt wird, auf die gereinigte Oberfläche eine Schicht auf Reineisen aufgebracht wird, auf die Schicht aus Reineisen eine sauerstoffhaltige, eisenbasierte Schicht aufgebracht wird, die mehr als 5 Massenprozent Sauerstoff enthält, danach das Stahlband mit der sauerstoffhaltigen, eisenbasierten Schicht glühbehandelt wird und zur Erzielung einer im Wesentlichen aus metallischem Eisen bestehenden Oberfläche im Zuge der Glühbehandlung in einer reduzierenden Ofenatmosphäre reduktionsbehandelt wird und anschließend das so behandelte und glühbehandelte Stahlband mit dem metallischen Überzug schmelztauchbeschichtet wird.

Weiterhin umfasst die Lehre der Erfindung ein Stahlband, aufweisend neben Kohlenstoff, Eisen als Hauptbestandteil, einen Mn-Gehalt von 8,1 bis 25,0 Gewichts-% und optional eines oder mehrere der Legierungselemente Al, Si, Cr, B, Ti, V, Nb und/oder Mo mit einem mittels Schmelztauchen auf die Stahlbandoberfläche aufgebrachten metallischen Überzug, welches dadurch gekennzeichnet ist, dass im Übergangsbereich zwischen metallischem Überzug und der Stahlbandoberfläche eine überwiegend ferritische Randzone mit mehr als 51 Volumen-% Ferrit ausgebildet ist, die eine Dicke von 0,25 bis 1,3 µm aufweist.

Auch umfasst die Lehre der Erfindung die Verwendung eines erfindungsgemäßen Stahlbandes zur Herstellung von Teilen für Kraftfahrzeuge.

Der Kern der Erfindung besteht in einer Kombination aus einer auf die Stahlbandoberfläche aufgebrachten Reineisenbeschichtung mit einer darüber abgeschiedenen sauerstoffhaltigen Eisenbeschichtung mit nachfolgender Glühung und Schmelztauchveredlung.

Als Reineisenschicht wird im Sinne der vorliegenden Erfindung eine Schicht mit einem durchschnittlichen Eisengehalt von mehr als 96 Gewichts-% verstanden.

Unter der sauerstoffhaltigen, eisenbasierten Schicht wird eine Schicht mit einem Eisengehalt in Gewichts-% von mindestens 50 % verstanden, die Sauerstoff von mehr als 5 Gewichts-% in Form von Oxiden und/oder Hydroxiden enthält.

Die Oxide und/oder Hydroxide können in der sauerstoffhaltigen, eisenbasierten Schicht sowohl in Form kristalliner, amorpher oder auch als Mischungen aus kristallinen, wie zum Beispiel Magnetit (Fe₃O₄), und amorphen Verbindungen vorliegen. Zusätzlich wird unter der sauerstoffhaltigen, eisenbasierten Schicht sowohl eine homogene stöchiometrische Eisenoxidschicht, z. B. eine Magnetitschicht (Fe₃O₄), als auch eine metallische Eisenschicht, die oxidische und/oder hydroxidische Einschlüsse (Dispersionsschicht) enthält, verstanden. Somit ist auch die Verteilung der amorphen und/oder kristallinen Verbindungen nicht eingeschränkt.

Die Schicht zeichnet sich somit dadurch aus, dass sie sauerstoffhaltige, reduzierbare Eisenspezies enthält.

In Untersuchungen hat sich herausgestellt, dass ohne eine Vorbeschichtung aus Reineisen, während der Glühbehandlung vor der Schmelztauchbeschichtung eine massive Ausscheidung von Oxiden der Legierungselemente am Übergang vom Stahlsubstrat zur sauerstoffhaltigen, eisenbasierten Schicht stattfindet, die das Gesamtsystem schwächt und zu einem Haftungsversagen führen kann. Mit der Vorbeschichtung aus Reineisen scheiden sich die Oxide der Legierungselemente weniger lokal konzentriert aus und es findet kein Haftungsversagen mehr statt.

Die Abscheidung der Reineisenschicht kann bevorzugt elektrolytisch oder durch Abscheidung aus der Gasphase (z. B. mittels PVD, CVD) erfolgen.

Bei der bevorzugten elektrolytischen Abscheidung der Reineisenschicht werden typischerweise sulfatische oder chloridische Elektrolyte sowie Kombinationen daraus eingesetzt, deren pH-Wert kleiner oder gleich 5,5 ist. Bei höheren pH-Werten fallen Eisen(II)-Spezies als Hydroxide aus. Als Anodenmaterial kommt vorzugweise Eisen mit einer Reinheit in Gewichts-% von größer 99,5 zum Einsatz. Auch können Elektrolysezellen mit getrennten Anoden- und Kathodenräumen zur Anwendung kommen, wodurch die Verwendung Sauerstoff erzeugendender bzw. unlöslicher Anoden ermöglicht wird. Zur Verringerung der Zellwiderstände kann optional ein Leitsalz dem Elektrolyten zugesetzt werden. Auch der Einsatz von weiteren Additiven, wie zum Beispiel Tensiden zur Verbesserung der Benetzung und oder Entschäumern ist möglich.

Die elektrolytische Abscheidung erfolgt bei Stromdichten, die unabhängig von der jeweiligen Bandgeschwindigkeit eine über die Bandlänge homogene Abscheidedicke ergeben. Weiterhin ist die Stromdichte von der Anodenbaulänge in Bandlaufrichtung abhängig. Typische Werte liegen zwischen 1 und 150 A/dm² pro Bandseite. Unterhalb von 1 A/dm² werden zu lange Behandlungslängen benötigt, wodurch der Prozess nicht wirtschaftlich betrieben werden kann. Bei Stromdichten oberhalb von 150 A/dm² wird eine homogene Abscheidung durch Anbrennungen oder Dendritenbildung deutlich erschwert. Die Dauer der elektrolytischen Abscheidung ist abhängig von der Behandlungslänge, der Stromdichte, der Stromausbeute und der gewünschten Schichtauflage und liegt typischerweise zwischen 1 s und 30 s je Seite. Beispielhafte Zusammensetzungen wässriger Elektrolyte und Abscheidebedingungen sind in Tabelle 1 gezeigt.

**Tabelle 1:**

| Elektrolytsystem | Zusammensetzung | Bedingungen |
|---|---|---|
| Sulfat | FeSO₄·7H₂O: 220 g/l | pH 2,2; 35 °C |
| | NaSO₄: 90 g/l | |
| Chlorid | FeCl₂·4H₂O: 280 g/l | pH 1,4; 48 °C |
| | KCl: 210 g/l | |
| Sulfat-Chlorid | FeSO₄·7H₂O: 400 g/l | pH 1,6; 85 °C |
| | FeCl₂·4H₂O: 400 g/l | |
| | CaCl₂: 180 g/l | |
| Sulfamat | Fe(SO₃NH₂)₂: 220 g/l | pH 3,2; 60 °C |
| | NH₄(SO₃NH₂): 30 g/l | |
| Fluoroborat | Fe(BF₄)₂: 240 g/l | pH 2,1; 58 °C |
| | NaCl: 8 g/l | |

In einer beispielhaften Ausführung erfolgt die Abscheidung der Reineisenschicht bei einer Elektrolyttemperatur von 60 °C mit einer Stromdichte von 30 A/dm² unter Einsatz einer Eisenanode mit einer Reinheit in Gewichts-% von größer 99,5 in einem wässrigen schwefelsauren Elektrolyten folgender Zusammensetzung: 60 g/l Eisen(II), 20 g/l Natrium, pH 1,8.

Die bevorzugte Abscheidung der sauerstoffhaltigen, eisenbasierten Schicht erfolgt elektrolytisch aus einem Fe(II)- und/oder Fe(III)-haltigen Elektrolyten. Hierzu werden typischerweise sulfatische oder chloridische Elektrolyte sowie Kombinationen daraus eingesetzt, deren pH-Wert in der Regel kleiner oder gleich 5,5 ist.

Auch der Einsatz eines basischen Elektrolyten mit einem pH-Wert > 10 ist jedoch unter Einsatz eines geeigneten Komplexbildners wie z.B. Triethanolamin (TEA) möglich. Die elektrolytische Abscheidung erfolgt bei Stromdichten, die unabhängig von der jeweiligen Bandgeschwindigkeit eine über die Bandlänge homogene Abscheidedicke ergeben. Weiterhin ist die Stromdichte von der Anodenbaulänge in Bandlaufrichtung abhängig. Typische Werte liegen zwischen 1 und 150 A/dm² pro Bandseite. Unterhalb von 1 A/dm² werden zu lange Behandlungslängen benötigt, wodurch der Prozess nicht wirtschaftlich betrieben werden kann. Bei Stromdichten oberhalb von 150 A/dm² wird eine homogene Abscheidung durch Anbrennungen oder Dendritenbildung deutlich erschwert. Die Abscheidezeit ist abhängig von der Behandlungslänge, der Stromdichte, der Stromausbeute und der gewünschten Schichtauflage und liegt typischerweise zwischen 1 s und 30 s je Seite. Beispielhafte Zusammensetzungen wässriger Elektrolyte und Abscheidebedingungen sind in Tabelle 2 gezeigt.

**Tabelle 2:**

| Komplexbildner | Zusammensetzung | Bedingungen |
|---|---|---|
| Citrat | FeSO₄·7H₂O: 350 g/l | pH 2,3; 45 °C |
| | Fe₂(SO₄)₃: 10 g/l | |
| | Na₂SO₄: 110 g/l | |
| | Natriumcitrat: 20 g/l | |
| Triethanolamin | Fe₂(SO₄)₃: 170 g/l | pH 13; 80 °C |
| | NaOH: 12 g/l | |
| | C₆H₁₅NO₃: 15 g/l | |

Zur Erzeugung sauerstoffhaltiger, eisenbasierter Schichten wird neben der genannten Fe(II)- und Fe(III)-Ionen auch im sauren Elektrolyten ein Komplexbildner für die Eisenionen benötigt. Hierbei handelt es sich typischerweise um eine Verbindung mit einer oder mehreren Carbonylfunktionalitäten, wie Zitronensäure, Essigsäure oder auch Nitrilotriessigsäure (NTA) oder Ethanolamin.

Als Anodenmaterial kommt vorzugsweise Eisen mit einer Reinheit in Gewichts-% von größer 99,5 zum Einsatz. Auch können Elektrolysezellen mit getrennten Anoden- und Kathodenräumen zur Anwendung kommen, wodurch die Verwendung Sauerstoff erzeugendender bzw. unlöslicher Anoden ermöglicht wird. Zur Verringerung der Zellwiderstände kann optional ein Leitsalz dem Elektrolyten zugesetzt werden. Auch der Einsatz von weiteren Additiven, wie zum Beispiel Tensiden zur Verbesserung der Benetzung und oder Entschäumern ist möglich.

In einer beispielhaften Ausführung erfolgt die Abscheidung der sauerstoffhaltigen Eisenschicht bei 60 °C mit einer Stromdichte von 30 A/dm² unter Einsatz einer Eisenanode mit einer Reinheit in Gewichts-% von größer 99,5 in einem wässrigen schwefelsauren Elektrolyten mit folgender Zusammensetzung: 60 g/l Eisen(II), 3 g/l Eisen(III), 25 g/l Natrium, 11 g/l Citrat, pH 1,8.

In einer bevorzugten, großtechnischen Umsetzung wird die Oberfläche des Stahlbandes vor der Abscheidung mit der Reineisenschicht vorzugsweise durch Reinigung in einem üblicherweise alkalischen, wässrigen Medium und einer anschließenden optionalen Dekapierung in einem sauren, wässrigen Medium aktiviert. Vorzugsweise kommt zur Dekapierung ein Schwefelsäurebad mit einem Säuregehalt von 20 bis 70 g/l bei Temperaturen von 30 bis 70 °C zur Anwendung. Die anschließende Beschichtung mit der sauerstoffhaltigen, eisenbasierten Schicht auf die zuvor abgeschiedene Reineisenschicht erfolgt vorzugsweise nass in nass, oder nach Trocknung der Stahlbandoberfläche. Nach der Abscheidung der sauerstoffhaltigen, eisenbasierten Schicht wird die Stahlbandoberfläche vorzugsweise getrocknet, um einen undefinierten Eintrag von Wasser in die Glühofenatmosphäre zu unterbinden. Um Verunreinigungen auf der Stahlbandoberfläche und oder Verschleppungen zwischen den verschiedenen Prozessmedien zu verhindern, kann optional nach jedem Prozessschritt eine Spüle verwendet werden. Die Abscheidung der Schichten kann dabei innerhalb einer oder in mehreren nacheinander angeordneten Elektrolysezellen erfolgen, deren Bauform vorzugsweise horizontal oder vertikal ausgeführt ist.

Untersuchungen haben ergeben, dass infolge der Vorbeschichtung aus Reineisen die sauerstoffhaltige, eisenbasierte Schicht besonders feinkristallin abgeschieden wird und zu einer besseren Haftung des Schmelztauchüberzugs führt, als wenn die sauerstoffhaltige, eisenbasierte Schicht unmittelbar auf die Stahloberfläche aufgebracht wird. Offensichtlich werden durch die Vorbeschichtung mit Reineisen die Keimbildungsbedingungen für die nachfolgende sauerstoffhaltige, eisenbasierte Schicht signifikant verbessert, wodurch sich die Keimbildungsrate erhöht und die Kristallitgröße deshalb im Vergleich zu einem Einschichtsystem abnimmt.

In vorteilhaften Weiterbildungen der Erfindung ist vorgesehen, dass die Reineisenschicht mit einer mittleren Dicke von 0,05 bis 0,6 µm und die sauerstoffhaltige, eisenbasierte Schicht mit einer mittleren Dicke von 0,2 bis 0,7 µm ausgebildet wird.

Als besonders vorteilhaft für verbesserte Haftungsbedingungen des Schmelztauchüberzugs hat sich herausgestellt, wenn die Reineisenschicht eine mittlere Dicke von 0,1 bis 0,4 µm und die sauerstoffhaltige, eisenbasierte Schicht eine mittlere Dicke von 0,3 bis 0,6 µm aufweist.

Zudem ist es vorteilhaft für die Haftung des Schmelztauchüberzugs, wenn die mittlere Dicke der sauerstoffhaltigen, eisenbasierten Schicht größer ist als die mittlere Dicke der Reineisenschicht.

Die sauerstoffhaltige, eisenbasierte Schicht weist in einer weiteren Ausgestaltung der Erfindung einen Anteil an Sauerstoff von mehr als 5 bis 40 Gewichts-% auf, vorteilhaft von mehr als 10 bis 30 Gewichts-%. In einer besonders vorteilhaften Ausgestaltung der Erfindung weist diese Schicht einen Sauerstoffgehalt von mehr als 12 bis 25 Gewichts-% auf.

Bei Untersuchungen hat sich herausgestellt, dass je mehr Sauerstoff in die Eisenschicht eingebaut wird, desto stärker die nachteilige externe Oxidation von Legierungselementen auf der Oberfläche unterdrückt werden kann, da dieser Sauerstoff bei der Glühung vor der Schmelztauchbeschichtung von den Legierungselementen zur internen Oxidation verwendet wird. Die Menge des in der sauerstoffhaltigen, eisenbasierten Schicht eingebauten Sauerstoffs hängt jedoch in einem wesentlichen Maße von den Abscheidebedingungen ab. Aufgrund von technischen und wirtschaftlichen Randbedingungen liegt der sinnvolle Maximalwert für den Sauerstoffgehalt bei 40 Gewichts-%.

Die Reineisenschicht selbst kann erfindungsgemäß entweder elektrolytisch oder durch Abscheidung aus der Gasphase aufgebracht werden, während die sauerstoffhaltige, eisenbasierte Schicht vorteilhaft elektrolytisch abgeschieden wird. Als Reineisenschicht wird eine Schicht mit einem durchschnittlichen Eisengehalt von mehr als 96 Gewichts-% verstanden.

Das Stahlsubstrat für ein erfindungsgemäß hergestelltes Stahlband mit einem metallischen Schmelztauchüberzug kann folgende Zusammensetzung in Gewichts-% aufweisen:
C: 0,1 % bis 1,0 %,
Mn: 8,1 % bis 25,0 %,
Si: 0,01 % bis 3,0 %,
Al: 1,0 % bis 8,0 %,
optional
Cr: 0,01 % bis 0,7 %,
B: 0,001 % bis 0,08 %,
Ti: 0,005 % bis 0,3 %,
V: 0,005 % bis 0,3 %,
Nb: 0,005 % bis 0,2 %,
Mo: 0,005 % bis 0,7 %,
P: ≤ 0,10 %,
S: ≤ 0,010 %,
Rest Eisen und unvermeidbare Verunreinigungen.

Das erfindungsgemäße Verfahren beinhaltet weiterhin eine Glühbehandlung des mit einer Reineisen und darauf aufgebrachten sauerstoffhaltigen, eisenbasierten Schicht versehenen Stahlbandes in einem Durchlaufglühofen. Dieser Ofen kann eine Kombination aus einem Ofenteil mit offener Verbrennung (DFF, Direct Fired Furnace / NOF, Non-Oxidizing Furnace) und einem danach angeordnetem Strahlrohrofen (RTF, Radiation Tube Furnace) sein oder aber in einem reinen Strahlrohrofen (All Radiant Tube Furnace) erfolgen. Das Stahlband wird bei einer Glühtemperatur von 550 °C bis 880 °C und einer mittleren Aufheizrate von 1 K/s bis 100 K/s, sowie einer Haltezeit des Stahlbandes auf Glühtemperatur zwischen 30 s und 650 s geglüht. Im Strahlrohrofen wird eine reduzierende Glühatmosphäre, bestehend aus 2 % bis 40 % H₂ und 98 bis 60 % N₂ und einem Taupunkt zwischen +15 °C und -70 °C verwendet. Anschließend wird das Band auf eine Temperatur oberhalb der Schmelzbadtemperatur des Überzugs abgekühlt und nachfolgend mit dem metallischen Überzug beschichtet. Optional kann nach der Glühbehandlung und vor der Beschichtung mit dem metallischen Überzug das Band auf eine so genannte Überalterungstemperatur zwischen 200 °C und 600 °C abgekühlt und bei dieser Temperatur für bis zu 500 s gehalten werden. Wird eine Überalterungstemperatur unterhalb der Schmelzbadtemperatur des Überzugs gewählt, um beispielsweise das Gefüge und die resultierenden technologischen Kennwerte des Stahls zu beeinflussen, so kann das Band vor dem Eintritt in das Schmelzbad beispielsweise durch eine induktive Erwärmung auf eine Temperatur oberhalb der Schmelzbadtemperatur zwischen 400 °C und 750 °C wiedererwärmt werden, um dem Schmelzbad nicht durch das kalte Stahlband Wärme zu entziehen.

Die Verwendung der erfindungsgemäßen Vorbeschichtungen macht eine zusätzliche Einleitung von Wasserdampf zur Erhöhung des Taupunktes, wie es bei den vorbekannten Verfahren üblich ist, unnötig. Für die Glühatmosphäre im Ofen hat es sich deshalb als ausreichend herausgestellt, wenn das Verhältnis der Partialdrücke von Wasserdampf und Wasserstoff bei der Glühung im Strahlrohrofen im Bereich 0,00077 > pH₂O/pH₂ > 0,00021, vorteilhaft zwischen 0,00254 > pH₂O/pH₂ > 0,00021 liegt.

Ein beispielhafter vorteilhafter Verfahrensablauf für die Herstellung eines erfindungsgemäßen Stahlbandes mit verbesserter Haftung einer Schmelztauchverzinkung sieht vor, dass zunächst ein warmgewalztes Stahlband (Warmband) gebeizt, danach kaltgewalzt und anschließend in einer Feuerverzinkungslinie verzinkt wird. Innerhalb der Feuerverzinkungslinie durchläuft das Band eine Vorreinigungssektion, nach der Vorreinigung durchläuft das Band weiter eine Bandaktivierung (Beize/Dekapierung) und nachfolgend 6 Elektrolysezellen. In den ersten 3 Zellen wird eine Eisenschicht abgeschieden, in den darauf folgenden 3 Zellen eine sauerstoffhaltige, eisenbasierte Schicht. Das beschichtete Band durchläuft anschließend Spüle und Trocknung. Anschließend läuft das Band in die Ofensektion der Verzinkungslinie ein, wird geglüht und verzinkt.

Als metallische Überzüge für das so geglühte Stahlband können beispielsweise Aluminium-Silizium (AS, AISi), Zink (Z), Zink-Aluminium (ZA, Galfan), Zink-Aluminium-Eisen (ZF, Galvannealed), Zink-Magnesium-Aluminium (ZM, ZAM) oder Aluminium-Zink (AZ, Galvalume) verwendet werden. In einer Ausgestaltung basiert der metallische Überzug auf Zink und der Zinküberzug enthält 0,1 bis 1 Gewichts-% Al oder 0,1 bis 6 Gewichts-% Al und 0,1 bis 6 Gewichts-% Mg oder 5 bis 15 Gewichts-% Fe.

Ein erfindungsgemäßes Stahlband ist weiterhin dadurch gekennzeichnet, dass im Übergangsbereich zwischen metallischem Überzug und der Stahlbandoberfläche eine überwiegend ferritische Randzone mit mehr als 60 Volumen-% Ferrit ausgebildet ist, die vorteilhaft eine Dicke von 0,25 bis 1,3 µm und besonders vorteilhaft eine Dicke zwischen 0,3 und 1,0 µm aufweist. Die Dicke dieser Randzone resultiert dabei unmittelbar aus den abgeschiedenen Vorbeschichtungen, die auch nach Glühung und Schmelztauchbeschichtung eine vom Stahlsubstrat abweichende Gefügeausprägung und damit die gewünschten positiven Effekte aufweist.

Tabelle 3 zeigt die Ergebnisse aus Aluminierungsversuchen, die an einem Schmelztauchsimulator mit Probeblechen aus Hochmanganstahl (15 Massenprozent Mn sowie 5 Massenprozent Si+Al) durchgeführt wurden. Die Abscheidung der Vorbeschichtungen erfolgte elektrolytisch mit einer Stromdichte von 75 A/dm² je Seite. Die Versuche wurden mit einer Wärmebehandlung bei 850 °C für 270 Sekunden durchgeführt. Proben mit vollständiger Überzugsbenetzung und guter Überzugshaftung konnten nur mittels einer Vorbeschichtung aus Reineisen und darüber angeordneter Vorbeschichtung aus einer sauerstoffhaltigen, eisenbasierten Schicht erzielt werden.

Die Überzugshaftung wurde mittels Kugelschlagtest gemäß SEP1931 geprüft. Bei dieser Prüfung wird ein Halbkugelstempel unter hoher Schlagenergie auf ein Probeblech geschlagen. Durch die Schlagbeanspruchung entsteht in dem Probeblech ein kalottenförmiger Eindruck. Dieser Vorgang wird bis zu einem leichten Anriss des Probeblechs, falls notwendig mehrfach, durchgeführt. Anschließend wird die Oberfläche visuell auf Enthaftungen und Abblätterungen des Überzugs im Bereich der Kalotte geprüft. Das Ergebnis wird mit Noten von 1-4 bewertet (Noten 1+2 bestanden, Noten 3+4 nicht bestanden).

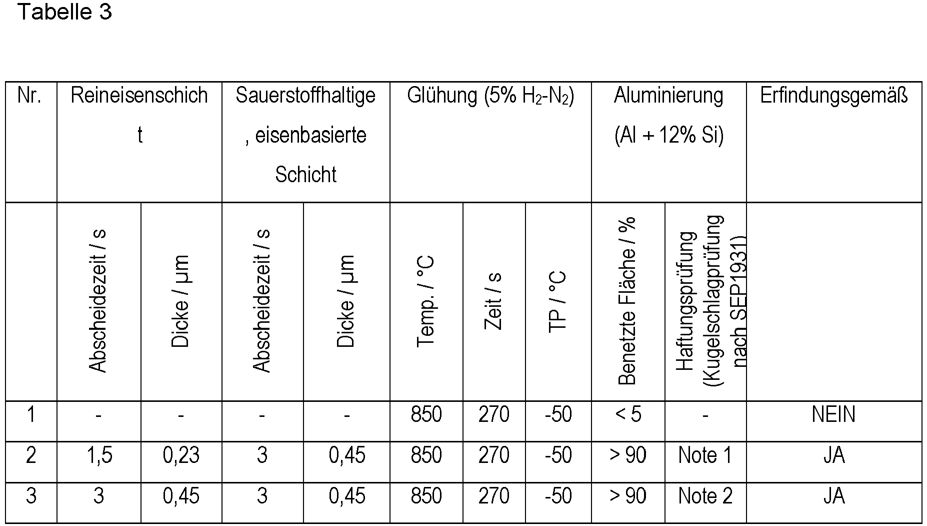

Die Vorteile der Erfindung lassen sich wie folgt zusammenfassen:
- reproduzierbare, gute Haftung des metallischen Überzugs auf dem Stahlsubstrat,
- Verbesserung der Verzinkbarkeit von Stählen mit hohen Mangangehalten zwischen 8,1 und 25 Massenprozent,
- Verbesserung der visuellen Oberflächenqualität des Schmelztauchüberzugs,
- Stähle mit sehr hohen Legierungselementgehalten lassen sich bislang großtechnisch häufig nur elektrolytisch verzinken und neigen aufgrund des eingebrachten Wasserstoffs bei diesem Prozess zur Wasserstoffversprödung; diese Gefahr besteht bei der erfindungsgemäßen Schmelztauchbeschichtung nicht. Zwar kann bei der erfindungsgemäßen elektrolytischen Abscheidung an der Kathode auch Wasserstoff als Nebenprodukt gebildet werden, der zunächst auf der Oberfläche atomar adsorbiert vorliegt und im späteren Verlauf durch das Stahlsubstrat absorbiert werden kann. Jedoch sind während des sich anschließenden Glühprozesses die Bedingungen für eine Effusion des eingebrachten Wasserstoffs gegeben.

## Patentansprüche

1. Verfahren zur Herstellung eines kalt- oder warmgewalzten Stahlbandes mit einem metallischen Überzug, das Stahlband Eisen als Hauptbestandteil und neben Kohlenstoff, einen Mn-Gehalt von 8,1 bis 25,0 Gewichts-% und optional eines oder mehrere der Legierungselemente AI, Si, Cr, B, Ti, V, Nb und/oder Mo aufweist, wobei die Oberfläche des unbeschichteten Stahlbandes zunächst gereinigt wird, auf die gereinigte Oberfläche eine Schicht aus Reineisen mit einem durchschnittlichen Eisengehalt von mehr als 96 Gewichts-% aufgebracht wird, auf die Schicht aus Reineisen eine sauerstoffhaltige, eisenbasierte Schicht aufgebracht wird, die mehr als 5 Massenprozent Sauerstoff enthält, danach das Stahlband mit der sauerstoffhaltigen, eisenbasierten Schicht glühbehandelt wird und im Zuge der Glühbehandlung in einer reduzierenden Ofenatmosphäre reduktionsbehandelt wird, und anschließend das so behandelte und glühbehandelte Stahlband mit dem metallischen Überzug schmelztauchbeschichtet wird.

2. Verfahren nach Anspruch 1, **dadurch gekennzeichnet, dass** eine mittlere Dicke der Reineisenschicht von 0,05 bis 0,6 µm, bevorzugt von 0,1 bis 0,4 µm, und eine mittlere Dicke der sauerstoffhaltigen, eisenbasierten Schicht von 0,2 bis 0,7 µm, bevorzugt von 0,3 bis 0,6 µm, ausgebildet wird.

3. Verfahren nach mindestens einem der Ansprüche 1 und 2, **dadurch gekennzeichnet, dass** die mittlere Dicke der sauerstoffhaltigen, eisenbasierten Schicht größer ist als die mittlere Dicke der Reineisenschicht.

4. Verfahren nach mindestens einem der Ansprüche 1 bis 3, **dadurch gekennzeichnet, dass** die sauerstoffhaltige, eisenbasierte Schicht mit einem Anteil an Sauerstoff von mehr als 5 bis 40 Gewichts-%, bevorzugt von mehr als 10 bis 30 Gewichts-%, besonders vorteilhaft von mehr als 12 bis 25 Gewichts-% auf die Reineisenschicht aufgebracht wird.

5. Verfahren nach mindestens einem der Ansprüche 1 bis 4, **dadurch gekennzeichnet, dass** die Reineisenschicht elektrolytisch oder durch Abscheidung aus der Gasphase und die sauerstoffhaltige, eisenbasierte Schicht elektrolytisch abgeschieden wird.

6. Verfahren nach mindestens einem der Ansprüche 1 bis 5, **dadurch gekennzeichnet, dass** das Stahlband folgende Zusammensetzung in Gewichts-% aufweist:
C: 0,1 % bis 1,0 %,
Mn: 8,1 % bis 25,0 %,
Si: 0,01 % bis 3,0 %,
AI: 1,0 % bis 8,0 %,
optional
Cr: 0,01 % bis 0,7 %,
B: 0,001 % bis 0,08 %,
Ti: 0,005 % bis 0,3 %,
V: 0,005 % bis 0,3 %,
Nb: 0,005 % bis 0,2 %,
Mo: 0,005 % bis 0,7 %,
P: ≤ 0,10 %,
S: ≤ 0,010 %,
Rest Eisen und unvermeidbare Verunreinigungen.

7. Verfahren nach mindestens einem der Ansprüche 1 bis 6, **dadurch gekennzeichnet, dass** die Glühbehandlung in einem Strahlrohrofen als Durchlaufglühofen durchgeführt wird, bei einer Glühtemperatur von 550 °C bis 880 °C und einer mittleren Aufheizrate von 1 K/s bis 100 K/s, mit einer reduzierenden Glühatmosphäre, bestehend aus 2 bis 40 % H₂ und 98 bis 60 % N₂ und einem Taupunkt im Glühofen zwischen +15 und -70 °C und einer Haltezeit des Stahlbandes auf Glühtemperatur zwischen 30 s und 650 s mit optionaler anschließender Abkühlung auf eine Haltetemperatur zwischen 200 °C und 600 °C für bis zu 500 s mit anschließender optionaler induktiver Erwärmung auf eine Temperatur oberhalb der Schmelzbadtemperatur des metallischen Überzugs auf 400 °C bis 750 °C und anschließend die Schmelztauchbeschichtung des Stahlbandes mit dem metallischen Überzug durchgeführt wird.

8. Verfahren nach mindestens einem der Ansprüche 1 bis 7, **dadurch gekennzeichnet, dass** das Verhältnis der Partialdrücke von Wasserdampf und Wasserstoff bei der Glühung im Strahlrohrofen im Bereich 0,00077 > pH₂O/pH₂ > 0,00021, vorteilhaft 0,00254 > pH₂O/pH₂ > 0,00021 liegt.

9. Verfahren nach mindestens einem der Ansprüche 1 bis 8, **dadurch gekennzeichnet, dass** als metallische Überzüge Aluminium-Silizium (AS, AISi), Zink (Z), Zink-Aluminium (ZA, Galfan), Zink -Eisen (ZF, Galvannealed), Zink-Aluminium -Magnesium (ZM, ZAM) oder Aluminium-Zink (AZ, Galvalume) verwendet werden.

10. Stahlband, aufweisend neben Kohlenstoff, Eisen als Hauptbestandteil, einen Mn-Gehalt von 8,1 bis 25,0 Gewichts-% und optional eines oder mehrere der Legierungselemente AI, Si, Cr, B, Ti, V, Nb und/oder Mo mit einem mittels Schmelztauchen aufgebrachten metallischen Überzug, **dadurch gekennzeichnet, dass** im Übergangsbereich zwischen metallischem Überzug und der Stahlbandoberfläche eine überwiegend ferritische Randzone mit mehr als 51 Volumen-% Ferrit ausgebildet ist, wobei die überwiegend ferritische Randzone eine Dicke von 0,25 bis 1,3 µm aufweist und von der Stahlbandoberfläche aus gesehen aus einer Reineisenschicht mit einem durchschnittlichen Eisengehalt von mehr als 96 Gewichts-% und darauf einer sauerstoffhaltigen, eisenbasierten Schicht besteht, die mehr als 5 Massenprozent Sauerstoff enthält.

11. Stahlband nach Anspruch 10, **dadurch gekennzeichnet, dass** die überwiegend ferritische Randzone eine Dicke zwischen 0,3 und 1,0 µm aufweist.

12. Stahlband nach mindestens einem der Ansprüche 10 und 11, **gekennzeichnet durch** folgende Zusammensetzung in Gewichts-%:
C: 0,1 % bis 1,0 %,
Mn: 8,1 % bis 25,0 %,
Si: 0,01 % bis 3,0 %,
AI: 1,0 % bis 8,0 %,
optional
Cr: 0,01 % bis 0,7 %,
B: 0,001 % bis 0,08 %,
Ti: 0,005 % bis 0,3 %,
V: 0,005 % bis 0,3 %,
Nb: 0,005 % bis 0,2 %,
Mo: 0,005 % bis 0,7 %,
P: ≤ 0,10 %,
S: ≤ 0,010 %,
Rest Eisen und unvermeidbare Verunreinigungen.

13. Stahlband nach mindestens einem der Ansprüche 10 bis 12, **gekennzeichnet durch** einen metallischen Überzug aus Aluminium-Silizium (AS, AISi), Zink (Z), Zink-Aluminium (ZA), Zink-Aluminium-Eisen (ZF/Galvannealed), Zink-Magnesium-Aluminium (ZM, ZAM) oder Aluminium-Zink (AZ).

14. Stahlband nach Anspruch 13, **dadurch gekennzeichnet, dass** bei einem metallischen Überzug basierend auf Zink, der Zinküberzug
0,1 bis 1 Gewichts-% Al oder
0,1 bis 6 Gewichts-% Al und 0,1 bis 6 Gewichts-% Mg oder
5 bis 15 Gewichts-% Fe enthält.

15. Verwendung eines nach mindestens einem der Ansprüche 1 bis 9 hergestellten Stahlbandes oder eines Stahlbandes nach mindestens einem der Ansprüche 10 bis 14 zur Herstellung von Teilen für Kraftfahrzeuge.

## Claims

1. Method for producing a cold or hot rolled steel strip comprising a metal coating, the steel strip comprising iron as the main component and, in addition to carbon, an Mn content of 8.1 to 25.0 wt.% and optionally one or more of the alloying elements Al, Si, Cr, B, Ti, V, Nb and/or Mo, wherein the surface of the uncoated steel strip is first cleaned, a layer of pure iron having an average iron content of greater than 96 wt.% is applied to the cleaned surface, an oxygen-containing, iron-based layer containing greater than 5 mass percent of oxygen is applied to the layer of pure iron, the steel strip is then subjected to annealing treatment together with the oxygen-containing, iron-based layer and, during the annealing, is subjected to reduction treatment in a reducing furnace atmosphere, and finally the steel strip thus treated and annealed is subjected to hot dip coating with the metal coating.

2. Method according to claim 1, **characterised in that** an average thickness of the pure iron layer is formed to be from 0.05 to 0.6 µm, preferably from 0.1 to 0.4 µm, and an average thickness of the oxygen-containing, iron-based layer is formed to be from 0.2 to 0.7 µm, preferably from 0.3 to 0.6 µm.

3. Method according to at least one of claims 1 and 2, **characterised in that** the average thickness of the oxygen-containing, iron-based layer is greater than the average thickness of the pure iron layer.

4. Method according to at least one of claims 1 to 3, **characterised in that** the oxygen-containing, iron-based layer having a proportion of oxygen of greater than 5 to 40 wt.%, preferably greater than 10 to 30 wt.%, particularly advantageously greater than 12 to 25 wt.%, is applied to the pure iron layer.

5. Method according to at least one of claims 1 to 4, **characterised in that** the pure iron layer is deposited electrolytically or by deposition from the gas phase and the oxygen-containing, iron-based layer is deposited electrolytically.

6. Method according to at least one of claims 1 to 5, **characterised in that** the steel strip has the following composition in wt.%:
C: 0.1% to 1.0%,
Mn: 8.1% to 25.0%,
Si: 0.01% to 3.0%,
Al: 1.0% to 8.0%,
optionally
Cr: 0.01% to 0.7%,
B: 0.001% to 0.08%,
Ti: 0.005% to 0.3%,
V: 0.005% to 0.3%,
Nb: 0.005% to 0.2%,
Mo: 0.005% to 0.7%,
P: ≤ 0.10%,
S: ≤ 0.010 %,
and the remainder iron and unavoidable impurities.

7. Method according to at least one of claims 1 to 6, **characterised in that** the annealing treatment is carried out in a radiant tube furnace as a continuous annealing furnace, at an annealing temperature of from 550°C to 880°C and an average heating rate of from 1 K/s to 100 K/s, with a reducing annealing atmosphere consisting of 2 to 40% H₂ and 98 to 60% N₂ and a dew point in the annealing furnace of between +15 and -70°C and a holding time of the steel strip at the annealing temperature of between 30 s and 650 s with optional subsequent cooling to a holding temperature of between 200°C and 600°C for up to 500 s with subsequent optional inductive heating to a temperature above the melt bath temperature of the metal coating at 400°C to 750°C and subsequently the hot dip coating of the steel strip with the metallic coating is carried out.

8. Method according to at least one of claims 1 to 7, **characterised in that** the ratio of the partial pressures of water vapor and hydrogen during the annealing in the radiant tube furnace is in the range 0.00077 > pH₂O/pH₂ > 0.00021, advantageously 0.00254 > pH₂O/pH₂ > 0.00021.

9. Method according to at least one of claims 1 to 8, **characterised in that** aluminium-silicon (AS, AISi), zinc (Z), zinc-aluminium (ZA, Galfan), zinc-iron (ZF, Galvannealed), zinc-aluminium-magnesium (ZM, ZAM) or aluminium-zinc (AZ, Galvalume) are used as metal coatings.

10. Steel strip, comprising, in addition to carbon, iron as the main component, an Mn content of 8.1 to 25.0 wt.% and optionally one or more of the alloying elements Al, Si, Cr, B, Ti, V, Nb and/or Mo together with a metal coating applied by means of hot dipping, **characterised in that** a predominantly ferritic edge zone having greater than 51 vol.% ferrite is formed in the transition region between the metal coating and the steel strip surface, the predominantly ferritic edge zone having a thickness of from 0.25 to 1.3 µm and, when viewed from the steel strip surface, consisting of a pure iron layer having an average iron content of greater than 96 wt.% and an oxygen-containing, iron-based layer thereon which contains greater than 5 mass percent of oxygen.

11. Steel strip according to claim 10, **characterised in that** the predominantly ferritic edge zone has a thickness of between 0.3 and 1.0 µm.

12. Steel strip according to at least one of claims 10 and 11, **characterised by** the following composition in wt.%:
C: 0.1% to 1.0%,
Mn: 8.1% to 25.0%,
Si: 0.01% to 3.0%,
Al: 1.0% to 8.0%,
optionally
Cr: 0.01% to 0.7%,
B: 0.001% to 0.08%,
Ti: 0.005% to 0.3%,
V: 0.005% to 0.3%,
Nb: 0.005% to 0.2%,
Mo: 0.005% to 0.7%,
P: ≤ 0.10%,
S: ≤ 0.010%,
and the remainder iron and unavoidable impurities.

13. Steel strip according to at least one of claims 10 to 12, **characterised by** a metal coating made of aluminium-silicon (AS, AISi), zinc (Z), zinc-aluminium (ZA), zinc-aluminium-iron (ZF/Galvannealed), zinc-magnesium-aluminium (ZM, ZAM) or aluminium-zinc (AZ).

14. Steel strip according to claim 13, **characterised in that**, with a metal coating based on zinc, the zinc coating contains
0.1 to 1 wt.% Al or
0.1 to 6 wt.% Al and 0.1 to 6 wt.% Mg or
5 to 15 wt.% Fe.

15. Use of a steel strip produced according to at least one of claims 1 to 9 or a steel strip according to at least one of claims 10 to 14 for producing parts for motor vehicles.

## Revendications

1. Procédé de production d'un feuillard en acier laminé à froid ou à chaud et pourvu d'un revêtement métallique, le feuillard en acier comportant du fer comme constituant principal et en plus du carbone, une teneur en Mn de 8,1 à 25,0 % en poids et éventuellement un ou plusieurs des éléments d'alliage Al, Si, Cr, B, Ti, V, Nb et/ou Mo, la surface du feuillard en acier non revêtu étant d'abord nettoyée, une couche de fer pur d'une teneur moyenne en fer supérieure à 96 % en poids étant appliquée sur la surface nettoyée, une couche à base de fer contenant de l'oxygène étant appliquée sur la couche de fer pur et contenant plus de 5 % en masse d'oxygène, puis le feuillard en acier étant recuit avec la couche à base de fer contenant de l'oxygène- et subissant un traitement de réduction au cours du traitement de recuit dans une atmosphère de four réductrice, puis le feuillard en acier ainsi traité et recuit étant revêtu du revêtement métallique dans un bain de fusion.

2. Procédé selon la revendication 1, **caractérisé en ce que** l'épaisseur moyenne de la couche de fer pur est de 0,05 à 0,6 µm, de préférence de 0,1 à 0,4 µm, et l'épaisseur moyenne de la couche à base de fer contenant de l'oxygène est de 0,2 à 0,7 µm, de préférence de 0,3 à 0,6 µm.

3. Procédé selon l'une au moins des revendications 1 et 2, **caractérisé en ce que** l'épaisseur moyenne de la couche à base de fer contenant de l'oxygène est supérieure à l'épaisseur moyenne de la couche de fer pur.

4. Procédé selon l'une au moins des revendications 1 à 3, **caractérisé en ce que** la couche à base de fer contenant du fer est appliquée sur la couche de fer pur avec une teneur en oxygène de plus de 5 à 40 % en poids, de préférence de plus de 10 à 30 % en poids, de manière particulièrement avantageuse de plus de 12 à 25 % en poids.

5. Procédé selon l'une au moins des revendications 1 à 4, **caractérisé en ce que** la couche de fer pur est déposée par voie électrolytique ou par dépôt en phase gazeuse et la couche à base de fer contenant de l'oxygène est déposée par voie électrolytique.

6. Procédé selon l'une au moins des revendications 1 à 5, **caractérisé en ce que** le feuillard en acier a la composition suivante en % en poids :
C: 0,1 % à 1,0 %,
Mn: 8,1 % à 25,0 %,
Si: 0,01 % à 3,0 %,
Al: 1,0 % à 8,0 %,
en option
Cr: 0,01 % à 0,7 %,
B: 0,001 % à 0,08 %,
Ti: 0,005 % à 0,3 %,
V: 0,005 % à 0,3 %,
Nb: 0,005 % à 0,2 %,
Mo: 0,005 % à 0,7 %,
P: ≤ 0,10 %,
S: ≤ 0,010 %,
le reste étant du fer et des impuretés inévitables.

7. Procédé selon l'une au moins des revendications 1 à 6, **caractérisé en ce que** le traitement de recuit est effectué dans un four tubulaire radiant utilisé comme four de recuit continu avec une température de recuit de 550°C à 880°C et une vitesse de chauffe moyenne de 1 K/s à 100 K/s, avec une atmosphère de recuit réductrice comprenant 2 à 40 % de H₂ et 98 à 60 % de N₂ et un point de rosée dans le four de recuit compris entre +15 et -70°C et un temps de séjour du feuillard en acier à une température de recuit compris entre 30 s et 650 s avec refroidissement ultérieur facultatif à une température de séjour comprise entre 200°C et 600°C pendant 500 s maximum avec chauffage inductif facultatif ultérieur à une température supérieure à la température du bain de fusion du revêtement métallique de 400°C à 750°C puis le revêtement du feuillard en acier dans le bain de fusion étant effectué avec le revêtement métallique.

8. Procédé selon l'une au moins des revendications 1 à 7, **caractérisé en ce que** le rapport des pressions partielles de vapeur d'eau et d'hydrogène lors du recuit dans le four tubulaire radiant est situé dans la gamme 0,00077 > pH₂O/pH₂ > 0,00021, avantageusement 0,00254 > pH₂O/pH₂ > 0,00021.

9. Procédé selon l'une au moins des revendications 1 à 8, **caractérisé en ce que** l'aluminium-silicium (AS, AlSi ), le zinc (Z), le zinc-aluminium (ZA, Galfan), le zinc-fer (ZF, trempé après zincage), le zinc-aluminium-magnésium (ZM, ZAM) ou l'aluminium-zinc (AZ, aluzinc) peuvent être utilisés comme revêtements métalliques.

10. Feuillard en acier comportant en plus du carbone, du fer comme constituant principal, une teneur en Mn de 8,1 à 25,0 % en poids et éventuellement un ou plusieurs des éléments d'alliage Al, Si, Cr, B, Ti, V, Nb et/ou Mo avec un revêtement métallique appliqué dans un bain de fusion, **caractérisé en ce qu'**une zone de bord essentiellement ferritique comprenant plus de 51 % en volume de ferrite est formée dans la zone de transition entre le revêtement métallique et la surface du feuillard en acier, la zone de bornd essentiellement ferritique ayant une épaisseur de 0,25 à 1,3 µm et comprenant une couche de fer pur d'une teneur moyenne en fer de plus de 96 % en poids et sur celle-ci une couche à base de fer contenant de l'oxygène qui contient plus de 5 % en masse d'oxygène, dans une vue depuis la surface du feuillard en acier.

11. Feuillard en acier selon la revendication 10, **caractérisé en ce que** la zone de bord enssentiellement ferritique a une épaisseur comprise entre 0,3 et 1,0 µm.

12. Feuillard en acier selon l'une au moins des revendications 10 et 11, **caractérisée par** la composition suivante en % en poids :
C: 0,1 % à 1,0 %,
Mn: 8,1 % à 25,0 %,
Si: 0,01 % à 3,0 %,
Al: 1,0 % à 8,0 %,
en option
Cr: 0,01 % à 0,7 %,
B: 0,001 % à 0,08 %,
Ti: 0,005 % à 0,3 %,
V: 0,005 % à 0,3 %,
Nb: 0,005 % à 0,2 %,
Mo: 0,005 % à 0,7 %,
P: ≤ 0,10 %,
S: ≤ 0,010 %,
le reste étant du fer et es impuretés inévitables.

13. Feuillard en acier selon l'une au moins des revendications 10 à 12, **caractérisé par** un revêtement métallique en aluminium-silicium (AS, AISi), zinc (Z), zinc-aluminium (ZA), zinc-aluminium-fer (ZF/trempé après zincage), zinc-magnésium-aluminium (ZM, ZAM) ou aluminium-zinc (AZ).

14. Feuillard en acier selon la revendication 13, **caractérisé en ce que**, dans le cas d'un revêtement métallique à base de zinc, le revêtement de zinc contient
0,1 à 1 % en poids d'AI ou
0,1 à 6 % en poids d'AI et 0,1 à 6 % en poids de Mg ou
5 à 15 % en poids de Fe.

15. Utilisation d'un feuillard en acier produit selon l'une au moins des revendications 1 à 9 ou d'un feuillard d'acier selon l'une au moins des revendications 10 à 14 pour la réalisation de pièces de véhicules automobiles.
